# EUROPEAN PATENT SPECIFICATION

(11) **EP 2 225 648 B1**
(45) Date of publication and mention of the grant of the patent: **28.08.2013**
(21) Application number: 08866072.5
(22) Date of filing: 22.09.2008
(51) Int. Cl.: G11C 16/30, G11C 16/00

(54) **SEMICONDUCTOR MEMORY DEVICE**
HALBLEITERSPEICHERVORRICHTUNG
DISPOSITIF DE MÉMOIRE À SEMI-CONDUCTEURS

(30) Priority: 28.12.2007 JP 2007340957
(43) Date of publication of application: 08.09.2010
(73) Proprietor: Kabushiki Kaisha Toshiba, Minato-ku Tokyo 105-8001 (JP)
(72) Inventor: SUGITA, Masato, Tokyo 105-8001 (JP); MAEDA, Keiji, Tokyo 105-8001 (JP)
(74) Representative: HOFFMANN EITLE
(86) International application number: PCT/JP2008/067596
(87) International publication number: WO 2009/084293

(56) References cited:
- DE-A1- 3 933 118
- JP-A- 10 171 936
- JP-A- 11 073 378
- US-A- 6 092 221
- US-A1- 2007 086 249

## Description

### TECHNICAL FIELD

The present invention relates to a semiconductor memory device such as a solid state drive (SSD) having a flash memory.

### BACKGROUND ART

An SSD that has a flash memory (flash electrically erasable programmable read only memory (EEPROM)) has attracted attention as an external or internal storage devices for a computer system, for example. The flash memory has advantages such as high speed and light weight over a magnetic disk device.

The SSD has therein a plurality of flash memory chips, a controller that performs read/write control for each of the flash memory chips according to a request from a host apparatus, a buffer memory that transmits data between each of the flash memory chips and the host apparatus, a power supply circuit, and a connection interface for connecting with the host apparatus (for example, Patent Document 1).

In the conventional SSD, however, an internal circuit cannot be protected when an overcurrent flows in the SSD. Due to the overcurrent, when a latch-up is generated in a CMOS mounting portion, malfunction of internal circuits may occur. The flash memory chips, among other internal circuits within the SSD, should be regarded in comparison with the other internal circuits as an important area to be protected from an overcurrent, because user data is stored therein.
[Patent Document 1] Japanese Patent No. 3688835

The present invention has been made in view of the above mentioned circumstance, and an object of the present invention is to provide a semiconductor memory device capable of protecting at least a flash memory portion from an overcurrent to prevent malfunction due to a latch-up and the like.

### DISCLOSURE OF INVENTION

One aspect of this invention is to provide a semiconductor memory device comprising a plurality of nonvolatile semiconductor memories; an external connecting terminal for connecting the solid state drive to a host apparatus; a cache memory for providing data transmission between the plurality of nonvolatile semiconductor memories and the host apparatus; a controller for performing control of the data transmission between the plurality of nonvolatile semiconductor memories and the host apparatus, and for causing the plurality of nonvolatile semiconductor memories to function as an external storage device of the host apparatus; a power supply circuit for converting an external power supply voltage, which is supplied from the external connecting terminal via an external power supply line, into a plurality of internal power supply voltages of which voltages are different one another to supply the converted plurality of internal power supply voltages to each of the nonvolatile semiconductor memories, the cache memory, and the controller, via an internal power supply line; a fuse disposed in the external power supply line; a package substrate for mounting thereon the plurality of nonvolatile semiconductor memories, external connecting terminal, the cache memory, the controller, the power supply circuit and the fuse, characterized in that the package substrate is rectangular in shape, and the external connecting terminal is disposed at a central edge area of one of the short sides of the package substrate; the controller, the power supply circuit, and the fuse are disposed at a first area between a proximity of the external connecting terminal and an edge of one of the long sides of the package substrate; the plurality of nonvolatile semiconductor memories is disposed at a second area between the first area and an edge area of the other one of the short sides of the package substrate; and the fuse is disposed closer to the external connecting terminal than the power supply circuit is to the external connecting terminal.

Another aspect of the invention is set out in claim 7,

### BRIEF DESCRIPTION OF DRAWINGS

Fig. 1 is a functional block diagram of a configuration example of a semiconductor memory device according to a first embodiment of the present invention.
Fig. 2 is a plane view of a layout example of components on a substrate of the semiconductor memory device shown in Fig. 1.
Fig. 3 is a functional block diagram of a part of a configuration of a semiconductor memory device according to a second embodiment of the present invention.

### BEST MODE(S) FOR CARRYING OUT THE INVENTION

Exemplary embodiments of a semiconductor memory device according to the present invention will be explained below in detail with reference to the accompanying drawings.

### First Embodiment

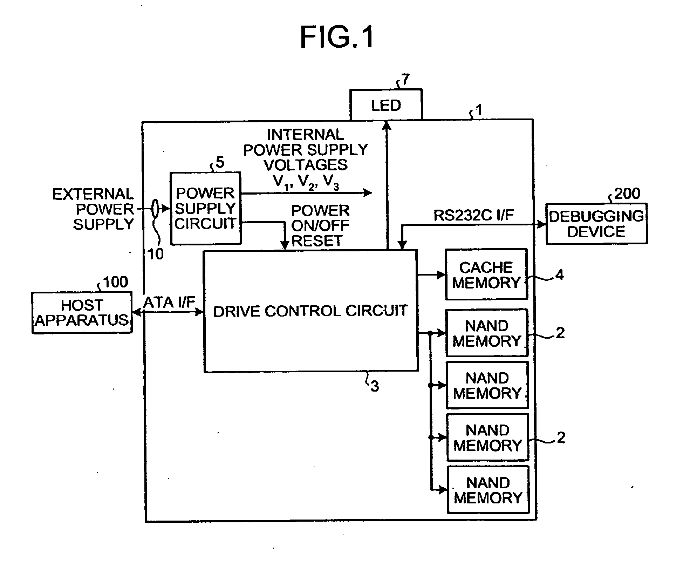

Fig. 1 is a block diagram of a functional configuration example of an internal circuit of an SSD as a semiconductor memory device according to a first embodiment of the present invention. In Fig. 1, an SSD 1 is connected to a host apparatus 100 such as a CPU core via a memory connection interface such as an At Attachment (ATA) interface, and functions as an external memory of the host apparatus 100. The SSD 1 can send data to and receive data from a debugging device 200 via a communication interface such as an RS232C interface. The SSD 1 includes a plurality of NAND flash memory chips (hereinafter, "NAND memories") 2, a drive control circuit 3 as a controller, a cache memory 4, a power supply circuit 5, a light emitting diode (LED) 7, and a fuse 10.

Each of the NAND memories 2 has a memory cell transistor structure in which electric charges are taken in and out between a silicon substrate and a floating gate through FN (Fowler Nordheim) current that flows on a front surface of a channel. The NAND memories 2 store therein data and application programs. In this case, a single NAND memory 2 shown in Fig. 1 represents a block that performs a parallel operation, and four blocks perform four parallel operations. Each of the NAND memories 2 has for example 16 NAND memory chips mounted thereon. The cache memory 4 is configured by a dynamic random access memory (DRAM) or the like, and functions as a cache for data transmission between the host apparatus and each one of the NAND memories 2 and as a work area memory. The drive control circuit 3 controls data transmission between the host apparatus 100 and each of the NAND memories 2 via the cache memory 4, and controls components in the SSD 1. The drive control circuit 3 supplies a status display signal to a status display LED 7, and receives a power on/off reset signal from the power supply circuit 5 to supply a reset signal and a clock signal to the respective units in its own circuit and the SSD 1.

The power supply circuit 5 generates a plurality of different internal direct current (DC) power supply voltages V1, V2, and V3 (for example, 3.3V, 1.8V, and 1.2V) from an external DC power supply supplied from a power supply circuit on the side of the host apparatus 100, and supplies these internal DC power supply voltages V1, V2, and V3 to each of the circuits within the SSD 1 via a plurality of internal power supply voltage lines. The power supply circuit 5 detects a rising edge or a falling edge of an external power supply, generates a power on reset signal or a power off reset signal, and supplies the generated signal to the drive control circuit 3.

In the first embodiment, the fuse 10 is provided on the input side of the power supply circuit 5 to prevent an overcurrent, when generated, from entering into any of the internal circuits and thereby to prevent malfunction of the internal circuits due to a latch-up or the like. As the fuse 10, a power fuse that melts down due to Joule heat generated, when a current exceeding a rated current flows, may be adopted, or a self-recovery type resettable fuse (poly fuse) which does not require replacement may be adopted. As the fuse 10, for example, a fuse that melts down or cuts off a current when a current that is double the rated current plus a certain margin value flows is adopted. In the first embodiment, the fuse 10 is provided to the external power supply line on the input side of the power supply circuit 5 to protect all the internal circuits in the SSD 1 from an overcurrent.

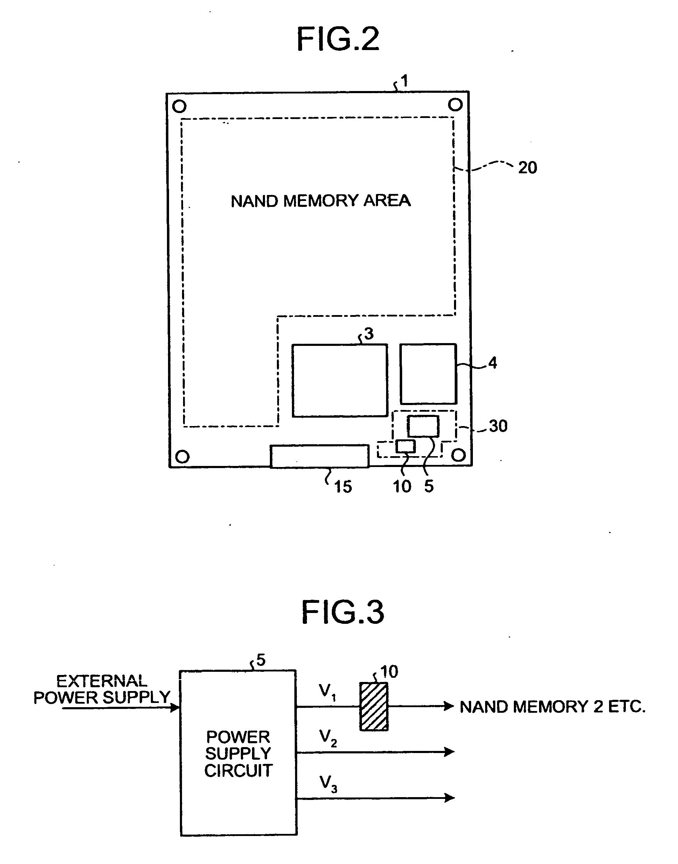

Fig. 2 is a plane view of a layout of the internal circuits of the SSD 1 shown in Fig. 1. As shown in Fig. 2, the NAND memories 2 are arranged in a NAND memory area 20 occupying most of the area of a package substrate. A connector 15 has an interface such as an ATA interface, and an RS232C formed therein. An external power supply is supplied to the power supply circuit 5 via the interfaces and an internal power supply wiring pattern, and connection is established between the host apparatus 100 or the debugging device 200 and the drive control circuit 3 via the interfaces.

The drive control circuit 3 is arranged closer to the connector 15 compared with the NAND memories 2 because the drive control circuit 3 needs to process high speed signal that is input/output via the ATA interface. The cache memory 4 is disposed adjacent to the drive control circuit 3. Because long and wide external power supply line is not preferable in terms of a layout, the power supply circuit 5 is disposed in an area 30 near the connector 15. Thus, the fuse 10 is also disposed in the area 30 near the connector 15. The NAND memory area 20 in which the NAND memories 2 are arranged is disposed around the drive control circuit 3, the cache memory 4, the power supply circuit 5, and the fuse 10. For example, the NAND memory area 20 may be disposed around the drive control circuit 3, along its long side and short side directions to maximize the memory capacity in a layout.

To conform to the size of a hard disk, area of the package substrate of the SSD is limited and, as shown in Fig. 2, the NAND memory area 20 occupies most of the area. Therefore, a number of circuits other than the NAND memory 2 have to be arranged in a small area. Generally, a power fuse that melts down is smaller than a resettable fuse. Therefore, when layout is limited as above, the layout work is easier with the power fuse.

As explained above, in the first embodiment, because the fuse 10 is provided on the input side of the power supply circuit 5 to protect all the internal circuits within the SSD 1, it is possible to protect the internal circuits within the SSD from an overcurrent so as to prevent malfunction due to a latch-up and the like. Accordingly adverse influence of heat from the latch-up on the host apparatus 100 can be prevented.

The SSD includes, a modular type provided in a substrate that is exposed without a case, and a complete product type provided in a substrate that is housed in a case. The modular type is more susceptible to noise, and latch-up occurs more frequently, compared with the complete product type. Therefore, effect of mounting the fuse 10 is more significant in the modular type.

### Second Embodiment

Fig. 3 shows a circuit configuration in periphery of the power supply circuit 5 in an SSD according to a second embodiment of the present invention. In the second embodiment, the fuse 10 is selectively provided only to an internal power supply line V1 connected to the NAND memory 2 among a plurality of internal power supply lines having different voltages (voltages V1, V2, and V3) output from the power supply circuit 5. Accordingly, even when an overcurrent occurs, at least the NAND memory 2 is protected from the overcurrent by current interruption by the fuse 10. The fuse 10 may be a power fuse or a resettable fuse.

Among the internal circuits of the SSD 1, the NAND memory 2 stores therein user data. Thus, by preventing malfunction of the NAND memory 2 by protecting it from an overcurrent by the fuse 10 provided in a post stage of the power supply circuit 5, the important user data stored in the NAND memory 2 can be taken up, and retrieved afterwards. In this case, retrieval of the data memorized in the NAND memory 2 is easier with the resettable fuse because it does not melt down like a power fuse.

Providing the fuse 10 to each one of the internal power supply lines (voltages V1, V2, and V3) output from the power supply circuit 5 facilitates an identification of a malfunctioning part. However, in the second embodiment, the fuse 10 is disposed only to a part that enables protection of at least the most important NAND memory due to the spatial issue described above.

As described above, in the second embodiment, the fuse 10 is provided in the internal power supply line to the NAND memory 2 on the output side of the power supply circuit 5 to protect at least the NAND memory 2 from an overcurrent. Accordingly, malfunction of the NAND memory 2 due to a latch-up and the like can be prevented. Accordingly, adverse influence of heat on the host apparatus 100 due to the latch-up can be prevented.

In the embodiments, the present invention is explained as being applied to the SSD having the NAND memory. The present invention may be applied to a SSD having other types of flash EEPROM such as NOR type.

According to the present invention, because the fuse is provided to protect at least a flash memory from an overcurrent, the flash memory portion can be protected from an overcurrent, and malfunction due to a latch-up and the like can be prevented.

## Claims

1. A solid state drive (1) comprising:
a plurality of nonvolatile semiconductor memories (2);
an external connecting terminal (15) for connecting the solid state drive (1) to a host apparatus (100);
a cache memory (4) for providing data transmission between the plurality of nonvolatile semiconductor memories (2) and the host apparatus (100);
a controller (3) for performing control of the data transmission between the plurality of nonvolatile semiconductor memories (2) and the host apparatus (100), and for causing the plurality of nonvolatile semiconductor memories (2) to function as an external storage device of the host apparatus (100);
a power supply circuit (5) for converting an external power supply voltage, which is supplied from the external connecting terminal (15) via an external power supply line, into a plurality of internal power supply voltages of which voltages are different one another to supply the converted plurality of internal power supply voltages to each of the nonvolatile semiconductor memories (2), the cache memory (4), and the controller (3), via an internal power supply line;
a fuse (10) disposed in the external power supply line;
a package substrate for mounting thereon the plurality of nonvolatile semiconductor memories (2), external connecting terminal (15), the cache memory (4), the controller (3), the power supply circuit (5) and the fuse (10), **characterized in that**
the package substrate is rectangular in shape, and the external connecting terminal (15) is disposed at a central edge area of one of the short sides of the package substrate;
the controller (3), the power supply circuit (5), and the fuse (10) are disposed at a first area between a proximity of the external connecting terminal (15) and an edge of one of the long sides of the package substrate;
the plurality of nonvolatile semiconductor memories (2) is disposed at a second area between the first area and an edge area of the other one of the short sides of the package substrate; and
the fuse (10) is disposed closer to the external connecting terminal (15) than the power supply circuit (5) is to the external connecting terminal (15)

2. The solid state drive (1) according to claim 1, wherein
the plurality of nonvolatile semiconductor memories (2) are further disposed at a third area between a proximity of the external connecting terminal (15) and an edge area of the other one of the long sides of the package substrate.

3. The solid state drive (1) according to claim 2, wherein the cache memory (4) is disposed at the first area.

4. The solid state drive (1) according to claim 1 to 3, wherein
the power supply circuit (5) is configured to supply the maximum voltage, among the plurality of internal power supply voltages, to the plurality of nonvolatile semiconductor memories (2) via the internal power supply line.

5. The solid state drive (1) according to claim 4, further comprising,
a fuse arranged in the internal power supply line that is connected to the plurality of nonvolatile semiconductor memories (2).

6. The solid state drive (1) according to claims 1 to 5, wherein
the plurality of nonvolatile semiconductor memories (2) is a NAND flash memory.

7. A solid state drive (1) comprising:
a plurality of nonvolatile semiconductor memories (2);
an external connecting terminal (15) for connecting the solid state drive (1) to a host apparatus (100);
a cache memory (4) for providing data transmission between the plurality of nonvolatile semiconductor memories (2) and the host apparatus (100);
a controller (3) for performing control of the data transmission between the plurality of nonvolatile semiconductor memories (2) and the host apparatus (100), and for causing the plurality of nonvolatile semiconductor memories (2) to function as an external storage device of the host apparatus (100);
a power supply circuit (5) for converting an external power supply voltage, which is supplied from the external connecting terminal (15) via an external power supply line, into a plurality of internal power supply voltages of which voltages are different one another, to supply the converted plurality of internal power supply voltages to each of the nonvolatile semiconductor memories (2), the cache memory (4), and the controller (3), via an internal power supply line, wherein the solid state drive further includes:
a fuse (10); and
a package substrate for mounting thereon the plurality of nonvolatile semiconductor memories (2), external connecting terminal (15), the cache memory (4), the controller (3), the power supply circuit (5) and the fuse(10), **characterized in that**
the fuse (10) being arranged in the internal power supply line that is connected to the plurality of nonvolatile semiconductor memories (2);
the package substrate is rectangular in shape, and the external connecting terminal (15) is disposed at a central edge area of one of the short sides of the package substrate;
the controller (3), the power supply circuit (5), and the fuse (10) are disposed at a first area between a proximity of the external connecting terminal (15) and an edge of one of the long sides of the package substrate; and
the plurality of nonvolatile semiconductor memories (2) is disposed at a second area between the first area and an edge area of the other one of the short sides of the short side of the package substrate.

8. The solid state drive (1) according to claim 7, wherein
the plurality of nonvolatile semiconductor memories (2) are further disposed at a third area between a proximity of the external connecting terminal (15) and an edge area of the other one of the long sides of the package substrate.

9. The solid state drive (1) according to claim 8, wherein
the cache memory (4) is disposed at the first area.

10. The solid state drive (1) according to claim 7 or 8, wherein
the power supply circuit (5) is configured to supply the maximum voltage, among the plurality of internal power supply voltages, to the plurality of nonvolatile semiconductor memories (2) via the internal power supply line.

11. The solid state drive (1) according to claims 7 to 10, wherein
the plurality of nonvolatile semiconductor memories (2) is a NAND flash memory.

## Patentansprüche

1. Solid-State-Drive (1), umfassend:
eine Vielzahl von nicht-flüchtigen Halbleiterspeichern (2);
einen externen Verbindungsanschluss (15) zum Verbinden des Solid-State-Drives (1) mit einer Host-Vorrichtung (100);
einen Cache-Speicher (4) zur Bereitstellung einer Datenübertragung zwischen der Vielzahl von nicht-flüchtigen Halbleiterspeichern (2) und der Host-Vorrichtung (100);
eine Steuerung (3) zum Durchführen einer Steuerung der Datenübertragung zwischen der Vielzahl von nicht-flüchtigen Halbleiterspeichern (2) und der Host-Vorrichtung (100), und um zu Bewirken, dass die Vielzahl von nicht-flüchtigen Halbleiterspeichern (2) als eine externe Speichervorrichtung der Host-Vorrichtung (100) arbeiten;
eine Stromversorgungsschaltung (5) zum Wandeln einer externen Stromversorgungsspannung, die über eine externe Stromversorgungsleitung von dem externen Verbindungsanschluss (15) geliefert wird, in eine Vielzahl von internen Stromversorgungsspannungen, deren Spannungen sich voneinander unterscheiden, zum Liefern der gewandelten Vielzahl interner Stromversorgungsspannungen an jeden der nicht-flüchtigen Halbleiterspeicher (2), den Cache-Speicher (4) und die Steuerung (3), über eine interne Stromversorgungsleitung;
eine Sicherung (10), angeordnet in der externen Stromversorgungsleitung;
ein Packungssubstrat zum Anbringen der Vielzahl von nicht-flüchtigen Halbleiterspeichern (2), des externen Verbindungsanschlusses (15), des Cache-Speichers (4), der Steuerung (3), der Stromversorgungsschaltung (5) und der Sicherung (10) darauf,
**dadurch gekennzeichnet, dass**
das Packungssubstrat eine rechteckige Form aufweist, und der externe Verbindungsanschluss (15) in einem zentralen Kantenbereich von einer der kurzen Seiten des Packungssubstrats angeordnet ist;
die Steuerung (3), die Stromversorgungsschaltung (5) und die Sicherung (10) in einem ersten Bereich zwischen einer Nähe des externen Verbindungsanschlusses (15) und einer Kante von einer der langen Seiten des Packungssubstrats angeordnet sind;
die Vielzahl von nicht-flüchtigen Halbleiterspeichern (2) in einem zweiten Bereich zwischen dem ersten Bereich und einem Kantenbereich der anderen der kurzen Seiten des Packungssubstrats angeordnet ist; und
die Sicherung (10) näher an dem externen Verbindungsanschluss (15) angeordnet ist als die Stromversorgungsschaltung (5) zu dem externen Verbindungsanschluss (15).

2. Solid-State-Drive (1) nach Anspruch 1, wobei
die Vielzahl von nicht-flüchtigen Halbleiterspeichern (2) ferner in einem dritten Bereich zwischen einer Nähe des externen Verbindungsanschlusses (15) und einem Kantenbereich der anderen der langen Seiten des Packungssubstrats angeordnet sind.

3. Solid-State-Drive (1) nach Anspruch 2, wobei der Cache-Speicher (4) in dem ersten Bereich angeordnet ist.

4. Solid-State-Drive (1) nach Anspruch 1 bis 3, wobei
die Energieversorgungsschaltung (5) konfiguriert ist zum Liefern der maximalen Spannung, unter der Vielzahl von internen Energieversorgungsspannungen, an die Vielzahl von nicht-flüchtigen Halbleiterspeichern (2) über die interne Stromversorgungsleitung.

5. Solid-State-Drive (1) nach Anspruch 4, ferner umfassend
eine Sicherung, die angeordnet ist in der internen Stromversorgungsleitung, die mit der Vielzahl von nicht-flüchtigen Halbleiterspeichern (2) verbunden ist.

6. Solid-State-Drive (1) nach Anspruch 1 bis 5, wobei
die Vielzahl von nicht-flüchtigen Halbleiterspeichern (2) ein NAND-Flash-Speicher ist.

7. Solid-State-Drive (1), umfassend:
eine Vielzahl von nicht-flüchtigen Halbleiterspeichern (2);
einen externen Verbindungsanschluss (15) zum Verbinden des Solid-State-Drives (1) mit einer Host-Vorrichtung (100);
einen Cache-Speicher (4) zum Bereitstellen einer Datenübertragung zwischen der Vielzahl von nicht-flüchtigen Halbleiterspeichern (2) und der Host-Vorrichtung (100);
eine Steuereinheit (3) zum Durchführen einer Steuerung der Datenübertragung zwischen der Vielzahl von nicht-flüchtigen Halbleiterspeichern (2) und der Host-Vorrichtung (100), und um zu Bewirken, dass die Vielzahl von nicht-flüchtigen Halbleiterspeichern (2) als eine externe Speichervorrichtung der Host-Vorrichtung (100) arbeiten;
eine Stromversorgungsschaltung (5) zum Wandeln einer externen Stromversorgungsspannung, die über eine externe Stromversorgungsleitung von dem externen Verbindungsanschluss (15) geliefert wird, in eine Vielzahl von internen Stromversorgungsspannungen, deren Spannungen sich voneinander unterscheiden, zum Versorgen der gewandelten Vielzahl interner Stromversorgungsspannungen an jeden der nicht-flüchtigen Halbleiterspeicher (2), den Cache-Speicher (4) und die Steuereinheit (3), über eine interne Stromversorgungsleitung,
wobei das Solid-State-Drive ferner aufweist;
eine Sicherung (10); und
ein Packungssubstrat zum Anbringen der Vielzahl von nicht-flüchtigen Halbleiterspeichern (2), des externen Verbindungsanschlusses (15), des Cache-Speichers (4), der Steuereinheit (3), der Stromversorgungsschaltung (5) und der Sicherung (10) darauf,
**dadurch gekennzeichnet, dass**
die Sicherung (10) in der internen Stromversorgungsleitung angeordnet ist, die mit der Vielzahl von nicht-flüchtigen Halbleiterspeichern (2) verbunden ist;
das Packungssubstrat eine rechteckige Form aufweist, und der externe Verbindungsanschluss (15) in einem zentralen Kantenbereich von einer der kurzen Seiten des Packungssubstrats angeordnet ist;
die Steuereinheit (3), die Stromversorgungsschaltung (5) und die Sicherung (10) in einem ersten Bereich zwischen einer Nähe des externen Verbindungsanschlusses (15) und einer Kante von einer der langen Seiten des Packungssubstrats angeordnet sind; und
die Vielzahl von nicht-flüchtigen Halbleiterspeichern (2) in einem zweiten Bereich zwischen dem ersten Bereich und einem Kantenbereich der anderen der kurzen Seiten des Packungssubstrats angeordnet sind.

8. Solid-State-Drive (1) nach Anspruch 7, wobei
die Vielzahl von nicht-flüchtigen Halbleiterspeichern (2) ferner in einem dritten Bereich zwischen einer Nähe des externen Verbindungsanschlusses (15) und einem Kantenbereich der anderen der langen Seiten des Packungssubstrats angeordnet sind.

9. Solid-State-Drive (1) nach Anspruch 8, wobei der Cache-Speicher (4) in dem ersten Bereich angeordnet ist.

10. Solid-State-Drive (1) nach Anspruch 7 oder 8, wobei
die Stromversorgungsschaltung (5) konfiguriert ist zum Liefern der maximalen Spannung, unter der Vielzahl von internen Stromversorgungsspannungen an die Vielzahl von nicht-flüchtigen Halbleiterspeichern (2) über die interne Stromversorgungsleitung.

11. Solid-State-Drive (1) nach Anspruch 7 bis 10, wobei
die Vielzahl von nicht-flüchtigen Halbleiterspeichern (2) ein NAND-Flash-Speicher ist.

## Revendications

1. Disque électronique (1) comprenant :
une pluralité de mémoires à semiconducteur non volatiles (2) ;
une borne de connexion externe (15) pour connecter le disque électronique (1) à un dispositif hôte (100) ;
une antémémoire (4) pour assurer la transmission des données entre la pluralité de mémoires à semiconducteur non volatiles (2) et le dispositif hôte (100) ;
un contrôleur (3) pour commander la transmission de données entre la pluralité de mémoires à semiconducteur non volatiles (2) et le dispositif hôte (100), et pour faire fonctionner la pluralité de mémoires à semiconducteur non volatiles (2) en tant que dispositif de stockage externe du dispositif hôte (100) ;
un circuit d'alimentation (5) pour convertir une tension d'alimentation externe, qui est fournie par la borne de connexion externe (15) par l'intermédiaire d'une ligne d'alimentation externe, en une pluralité de tensions d'alimentation internes, tensions qui sont différentes les unes des autres, pour fournir la pluralité convertie de tensions d'alimentation internes à chacune des mémoires à semiconducteur non volatiles (2), à l'antémémoire (4) et au contrôleur (3), par l'intermédiaire d'une ligne d'alimentation interne ;
un fusible (10) disposé dans la ligne d'alimentation externe ;
un substrat de boîtier pour monter sur celui-ci la pluralité de mémoires à semiconducteur non volatiles (2) la borne de connexion externe (15) l'antémémoire (4), le contrôleur (3), le circuit d'alimentation (5) et le fusible (10), **caractérisé en ce que**
le substrat de boîtier est de forme rectangulaire, et la borne de connexion externe (15) est disposée dans une zone de bord central de l'un des côtés courts du substrat de boîtier ;
le contrôleur (3), le circuit d'alimentation (5) et le fusible (10) sont disposés dans une première zone située entre le voisinage de la borne de connexion externe (15) et un bord de l'un des côtés longs du substrat de boîtier ;
la pluralité de mémoires à semiconducteur non volatiles (2) est disposée dans une deuxième zone située entre la première zone et une zone de bord de l'autre côté des côtés courts du substrat de boîtier ; et
le fusible (10) est disposé plus près de la borne de connexion externe (15) que ne l'est le circuit d'alimentation (5) de la borne de connexion externe (15).

2. Disque électronique (1) selon la revendication 1, dans lequel la pluralité de mémoires à semiconducteur non volatiles (2) est disposée en outre dans une troisième zone située entre le voisinage de la borne de connexion externe (15) et une zone de bord de l'autre côté des côtés longs du substrat de boîtier.

3. Disque électronique (1) selon la revendication 2, dans lequel l'antémémoire (4) est disposée dans la première zone.

4. Disque électronique (1) selon les revendications 1 à 3, dans lequel
le circuit d'alimentation (5) est configuré pour fournir la tension maximale de la pluralité de tensions d'alimentation internes, à la pluralité de mémoires à semiconducteur non volatiles (2) par l'intermédiaire de la ligne d'alimentation interne.

5. Disque électronique (1) selon la revendication 4, comprenant en outre,
un fusible agencé dans la ligne d'alimentation interne qui est connectée à la pluralité de mémoires à semiconducteur non volatiles (2).

6. Disque électronique (1) selon les revendications 1 à 5, dans lequel
la pluralité de mémoires à semiconducteur non volatiles (2) est constituée d'une mémoire flash NON ET.

7. Disque électronique (1) comprenant :
une pluralité de mémoires à semiconducteur non volatiles (2) ;
une borne de connexion externe (15) pour connecter le disque électronique (1) à un dispositif hôte (100) ;
une antémémoire (4) pour assurer la transmission des données entre la pluralité de mémoires à semiconducteur non volatiles (2) et le dispositif hôte (100) ;
un contrôleur (3) pour commander la transmission de données entre la pluralité de mémoires à semiconducteur non volatiles (2) et le dispositif hôte (100), et pour faire fonctionner la pluralité de mémoires à semiconducteur non volatiles (2) en tant que dispositif de stockage externe du dispositif hôte (100) ;
un circuit d'alimentation (5) pour convertir une tension d'alimentation externe, qui est fournie par la borne de connexion externe (15) par l'intermédiaire d'une ligne d'alimentation externe, en une pluralité de tensions d'alimentation internes, tensions qui sont différentes les unes des autres, pour fournir la pluralité convertie de tensions d'alimentation internes à chacune des mémoires à semiconducteur non volatiles (2), à l'antémémoire (4) et au contrôleur (3), par l'intermédiaire d'une ligne d'alimentation interne, dans lequel le disque électronique comporte en outre :
un fusible (10) ; et
un substrat de boîtier pour monter sur celui-ci la pluralité de mémoires à semiconducteur non volatiles (2) la borne de connexion externe (15) l'antémémoire (4), le contrôleur (3), le circuit d'alimentation (5) et le fusible (10), **caractérisé en ce que**
le fusible (10) est agencé dans la ligne d'alimentation interne qui est connectée à la pluralité de mémoires à semiconducteur non volatiles (2) ;
le substrat de boîtier est de forme rectangulaire, et la borne de connexion externe (15) est disposée dans une zone de bord central de l'un des côtés courts du substrat de boîtier ;
le contrôleur (3), le circuit d'alimentation (5) et le fusible (10) sont disposés dans une première zone située entre le voisinage de la borne de connexion externe (15) et un bord de l'un des côtés longs du substrat de boîtier ; et
la pluralité de mémoires à semiconducteur non volatiles (2) est disposée dans une deuxième zone située entre la première zone et une zone de bord de l'autre côté des côtés courts du substrat de boîtier.

8. Disque électronique (1) selon la revendication 7, dans lequel la pluralité de mémoires à semiconducteur non volatiles (2) est disposée en outre dans une troisième zone située entre le voisinage de la borne de connexion externe (15) et une zone de bord de l'autre côté des côtés longs du substrat de boîtier.

9. Disque électronique (1) selon la revendication 8, dans lequel l'antémémoire (4) est disposée dans la première zone.

10. Disque électronique (1) selon la revendication 7 ou 8, dans lequel le circuit d'alimentation (5) est configuré pour fournir la tension maximale de la pluralité de tensions d'alimentation internes, à la pluralité de mémoires à semiconducteur non volatiles (2) par l'intermédiaire de la ligne d'alimentation interne.

11. Disque électronique (1) selon les revendications 7 à 10, dans lequel la pluralité de mémoires à semiconducteur non volatiles (2) est constituée d'une mémoire flash NON ET.
